# EUROPEAN PATENT APPLICATION

(11) **EP 3 038 027 A1**
(43) Date of publication of application: **29.06.2016**
(21) Application number: 16150109.3
(22) Date of filing: 01.10.2012
(51) Int. Cl.: G06Q 10/06, G06Q 50/04, G06F 17/50

(54) **COMPUTER AIDED DESIGN OF COMPONENTS OF A DRIVE TRAIN**

(30) Priority: 29.09.2011 GB 201116797
(62) Divisional of application: 12186876.4
(71) Applicant: Romax Technology Limited, Nottingham, Nottinghamshire NG7 2TU (GB)
(72) Inventor: James, BARRY, Cranage, Cheshire CW4 8EX (GB)

(57) **Abstract**

A method of computer aided engineering for designing a rotating machine assembly involves creating within a graphical user interface of a computer system a layout of said rotating machine assembly, and forming a functional model 210 of the rotating machine assembly from the layout. The layout is created by selecting and positioning components 204,206 for the rotating machine assembly, and then creating associations between them. The functional model is based on one or more of the associations, relative positions of the selected components, properties of the selected components and properties of the associations.

## Description

The present invention is related to the design of transmission systems and drive trains using computer-aided engineering, in particular those transmission systems and drive trains comprising rotating machine assemblies comprised of gears, generators, motors, rotors, stators, clutches, shafts and bearings. In the context of the present invention, it is to be understood that the term transmission refers to a whole drive train, which may include input shafts, gearboxes, clutches, shafts, driveshafts, electric motors, generators, axles, transfer boxes, differential gears, power take off units, auxiliary power units, wheel hub reduction units, steering systems, timing gear trains, and output shafts.

Designing a rotating machine, such as a complex transmission or gearbox arrangement is complex and time consuming. Designers often use conceptual models, such as a "stick diagram" in preliminary stages of design, and these provide an easy way to view functional relationships between components. Such diagrams help designers of rotating machines to conceptualise their designs without reverting to in-depth structural analysis or detailed engineering drawings. Initially they can define these functional relationships without having to define information about sizing and packaging of components.

Once the basic function of the concept or concepts for a given rotating machine arrangement has been fixed, the arrangement is subject to more detailed structural analysis, usually performed by many engineers of specialised backgrounds, to define the powerflows, determine the sizes of components, the packaging of components, loads, power, performance and the like. This information is derived from detailed structural analysis and simulation of the rotating machine. This often results in the identification of shortcomings in the original concept, and changes to the layout are often required. This means that the design process for complex machinery is iterative, time-consuming and therefore expensive.

There is a need for a simple and efficient layout approach for designing an assembly, which provides layout information to a variety of analytical methods, and which allows further technical details to be added to the layout as the design of the assembly evolves.

The present invention provides a solution to this problem by providing an approach for associating the conceptual approach, which allows the designer to layout the design simply, with properties and attributes of the elements of the design to model the rotating machine. This reduces the time taken to arrive at a design in which a number of the previous unknown features are now present.

Thus transmission designers can sketch out transmission configurations as "stick diagrams" to represent not only the structure of the given design but also its functionality.

The method of the present invention is implemented in a CAE package. The following are key features of the functionality and "feel" of the present invention.

The present invention provides a method of computer-aided engineering for designing a rotating machine assembly. The method comprising the steps of: creating within a graphical user interface of a computer system a layout of said rotating machine assembly, and forming a functional model of the rotating machine assembly from the layout. The layout it created by the steps of: receiving a user selection of components for the rotating machine; positioning the selected components; and creating associations between the selected components. The functional model is based on one or more of the associations, relative positions of the selected components, properties of the selected components and properties of the associations. It allows, for example, stick-diagram type modelling of a complete transmission system in a CAE package. Transmission designers sketch out transmission configurations as "stick diagrams" and this is used to represent the structure and functionality of the given design. In the present invention this is implemented in a CAE (Computer-Aided Engineering) package.

Preferably, the method also includes predicting a performance of the rotating machine assembly. The prediction of performance is done within the graphical user interface, by linking to an integrated user interface, or by exporting data to a third party package. The stick diagram is a functional or "working" model of a transmission, on which calculations can be carried out. Thus it is not just a graphical representation of a transmission, but a functional model of the transmission; it is a product definition on which calculations can be carried out to predict the function and performance of a transmission. Stick diagram yields a 3D model of a transmission that can be exported to CAD for a check of the packaging of the transmission within its environment. Although the graphical user interface is in 2D, orthogonal views allow the 3D representation of the transmission to be defined. This is exported as solid geometry to a CAD package so that the size and shape of the transmission can be checked relative to the space into which it will eventually have to be assembled. All of this can be achieved with a bare minimum of details of the design having been completed.

Preferably, the step of predicting comprises reporting performance of the rotating machine assembly. Performance criteria include a power flow through the rotating machine assembly or selected components; a gear sizing; a gear torque capacity and centre distance safety factor; a clutch torque capacity; a packaging space; bearing loads; a suitable dynamic load factor corresponding to a minimum required dynamic capacity of a roller bearing; a load on a housing or casing a weight of the components and assembly; and/or an estimate of cost.

Preferably, the method includes modifying the model to achieve increasing product performance. This can be done by modifying the layout according to the steps of: receiving a user selection of one or more new or existing components for the rotating machine; positioning the selected new or existing components; creating associations between the selected new or existing components; and updating the functional model. It can also be done by modifying one or more of the properties according to the steps of: receiving a user selection of a component or association; setting or modifying a property of the selected component or of the selected association according to a user request; and updating said functional model. This process can be executed a number of times to form an increasingly complex functional model. Preferably, the step of setting or modifying a property comprises a click-and-drag action.

Preferably, the selected component is a gear set and the property is a gear ratio, and the step of modifying the gear ratio automatically modifies the diameters of the corresponding gears without any need for further user interaction. Preferably, the selected component is a shaft or assembly of concentric shafts and the property is its radial distance to other parallel shafts which define the centre distances of the gear sets mounted on the shafts, and the step of modifying the centre distances automatically modifies diameters of the corresponding gears without any need for further user interaction. Preferably, the selected component is a gear and the property is a face width, and the step of modifying the face width automatically modifies the packaging space or torque capacity of the gear without any need for further user interaction. The simplest assessment of the size of the gears is carried out by simple methods that require no knowledge of gearing. Normally, the assessment of the suitable torque capacity or durability of a gear is made using "rating" methods such as ISO 6336 or AGMA 2001, which require input data such as number of teeth, pressure angle, module, addendum, dedendum etc. Therefore they require the engineer to have defined the gears in sufficient detail and also to have knowledge of the appropriate values. In the present invention simpler "sizing" methods are used for external gear sets, which require (i) centre distance only (ii) centre distance and face width (iii) centre distance, face width and ratio. Whilst these methods are not as accurate or sophisticated as rating methods, they are usable by engineers who are not familiar with the details of gear design and so can be used for the initial stages of transmission and gear design. Similarly, one simple method is used for planetary gear sets, which requires ring gear (or sun gear) diameter and ratio only. Further, all the gears defined in this way have a ratio assigned to them as one of the properties. The pinion diameter is directly calculable from the centre distance and the ratio; hence the same methods are available in the form where pinion diameter replaces centre distance. Constants used for these simple sizing methods can be derived from analysis of existing transmissions using the same package. Such sizing methods require "constants", related to the application and material used, which can be obtained by analysing existing transmissions using the same simple analysis methods. In the present invention, the same tool can be used to analyse an existing transmission, this data is saved to a database and can be used once more in the creation of new transmissions.

Preferably, where the component is a shaft having steps formed therein to allow different outer diameters to be applied to different sections and the property is an outer diameter of the shaft, the step of modifying the outer diameter automatically modifies an inner diameter of the shaft so as to maintain a relationship between the inner and outer diameters without any need for further user interaction. Preferably, when an inner diameter of one section becomes greater than an outer diameter of an adjacent section, the step of modifying defines two steps, separated axially by a default thickness between the inner and the outer diameters of the shaft and acting as a transition between the shaft sections. The creation and manipulation of the transitional step is performed automatically.

Preferably, the selected component is a Ravigneaux planetary gear set in which each planet set of said Ravigneaux is either a plus-planet or minus-planet and said property is a gear ratio sign, wherein said step of modifying said Ravigneaux comprises selecting the ratio sign of the gear set. Ravigneaux planetary gear sets are created as a single object in a single user action. Ravigneaux gear sets are complex arrangements of gears but are commonly used for automatic transmissions in the automotive industry. In this software package they are reduced to their most abstract level so that an initial basic model is created by defining the two basic ratios of the Ravigneaux set and the basic structure (two suns and one ring gear or two rings gears and one sun). Even with this simple definition, the Ravigneaux can be connected to other planetary sets and clutches to achieve several ratios for the overall transmission, thus initiating the transmission design process with minimum effort for the engineer. Different Ravigneaux configurations are achieved simply by specifying the sign of the ratio. The different possible structures, whereby each planet of the Ravigneaux set is either a plus-planet or minus-planet, is selected with a minimum of user input and effort simply by defining the sign of the relevant gear set. The design and modelling process is thus as smooth and as intuitive as possible.

Preferably the step of the reporting is reporting a gear torque capacity and safety factor. The gear torque capacity is calculated from: centre distance or pinion diameter; centre distance or pinion diameter and face width; centre distance or pinion diameter, face width and gear ratio; or ring gear (or sun gear) diameter, face width and ratio; and a respective constant kn, where n=1 to 4. The recommended centre distance or ring gear diameter is calculated from: torque and ratio; torque, face width and gear ratio; or torque, face width and ratio; and a respective constant kn, where n=1 to 4.

Preferably, the selected component is a gear pair and the property is a centre distance for a gear pair or gear set, the step of setting the centre distance comprises determining the recommended centre distance from only: torque and ratio; or torque, ratio and face width; and a respective constant kn, where n=1 to 3.

Preferably, the selected component is a planetary gear set and the property is the ring gear diameter, the step of setting the ring gear diameter comprises determining the recommended ring gear diameter from only torque, ratio and face width; and a respective constant k4.

Preferably, the components include gears, gear sets, epicyclic gear sets, Ravigneaux planetary gear sets, hypoid gears, spiral bevel gears, skew gears, face gears generators, motors, rotors, stators, clutches, shafts pumps, turbines or bearings.

Preferably one such component is a simple shaft support bearing and comprises no user-defined information on the radial, axial or tilt stiffness. Preferably, additional stiffness data is defined by the user or calculated in the step of forming the functional model.

Preferably the model is modified so as to provide increased model complexity and its performance is assessed using analysis methods that are increasingly complex.

Preferably, the representation of the layout includes a schematic diagram, an orthogonal diagram, a profile diagram or a stick model, and the representation is interchangeable between these. The Stick diagram transposes to a "profile" diagram and vice versa. A "stick diagram" is a very efficient and logical way of representing a transmission that consists of external gear sets. The shaft is drawn along its centre line. However, where planetary gear sets are involved, or systems with many concentric shafts are involved, it is necessary to represent the shafts in terms of the outer diameter of the shaft rather than the centre line, or in terms of outer diameter and inner diameter. This is referred to as a "profile" diagram. A further refinement is that the user can automatically switch between views.

Preferably, the rotating machine assembly includes gear-boxes, drive trains, transmissions, electric motors, generators, pumps, and turbines.

The present invention also provides a computer readable product for computer-aided engineering design of a rotating machine assembly, which comprises code means designed for implementing the steps of the method disclosed above.

The present invention also provides a computer-aided engineering design of a rotating machine assembly, which comprises code means designed for implementing the steps of the method disclosed above.

When creating the planetary sets, they are full assemblies, already mounted on shafts. When all planetary sets are created, they are created as complete assemblies, not just in terms of the gears that mesh, but also the mounting onto shafts and the creation of suitable planet carriers. This allows a quick start to the transmission design and modelling process, so that their inclusion into a complete transmission can be carried out as quickly as possible. Similarly, roller bearings can be included under the planet gears.

The size of all clutch packs and all gear sets in a transmission are assessed within a single user window. Within the transmission design process, the principal components affecting the overall size of the transmission are gears and clutches. Both have to be sufficiently big to transmit the torque, but there is a cost to excessive size in that it makes the transmission difficult to fit within the eventual application. In this package, the size (hence packaging) of all gear sets and all clutches can be modified in a single GUI window, with key results on their performance (torque capacity, cost and weight) being reported simultaneously.

This overall design process also includes hypoid, spiral bevel, skew and face gears.

1 D torsional model for dynamic analysis is automatically created. From a simple, stick-diagram representation of the transmission, a 1 D torsional dynamic analysis model is automatically created. This can be exported to another CAE package for the creation of a gear shift model or shift strategy etc.

The present invention enables a transmission to be designed and the connections between the components and the powerflows to be defined. The design can be analysed for the given model parameters. The transmission aims for all the components to have sufficient torque capacity, yet the transmission needs to be small enough for the packaging space in the application and to be as light and cheap as possible.

In a further embodiment, the present invention allows the transmission design to be automatically modified according to certain rules, with the simple analysis methods (as disclosed above) applied to the transmission so as to check the performance. Many different variants of the same transmission layout can be studied in a short period of time, and the best candidate can be presented to the user.

For example, where the overall ratio is fixed but consists of the product of two or more intermediate ratios, the split between these ratios can be automatically varied between extremes, with the resulting transmission variants having different weights, torque capacities and packaging.

In many automotive examples, different overall gear ratios are inter-related, so that the ratio split of one gear set alters the ratio split in another. The package understands this relationship and reports the relevant results in its automatic design study.

Centre distances can be varied, automatically altering the torque capacity, weight, cost and packaging. In the case where there are two or more shaft axes of rotation, the user can define the way in which centre distances vary the relative positions of the shafts in accordance with the design intent.

As an example, many design parameters can be varied in the model, including: gear face widths, gear positions, gear-gear offset, clutch diameter, clutch length etc. However, so as to restrict the design study to a size that provides satisfactory results that can be understood in a suitable manner, the user can select which variable to include and which to exclude.

The present invention will now be described, by way of example only, with reference to the accompanying drawings, in which:
Fig. 1 shows a flow chart of a process for designing a rotating machine and includes design iteration at the same level of complexity;
Fig. 2 shows the export of data to a separate package, which may be integrated or discrete.
Figs. 3A-D show approaches for creating functional models of increasing complexity;
Fig. 4 shows an example of a graphical user interface displayed to the user and which allows the user to interact with the method of the invention;
Fig. 5 shows a list of icons and associated commands;
Fig. 6 shows examples of stick model style schematics; and
Fig. 7 shows examples of a Profile view.

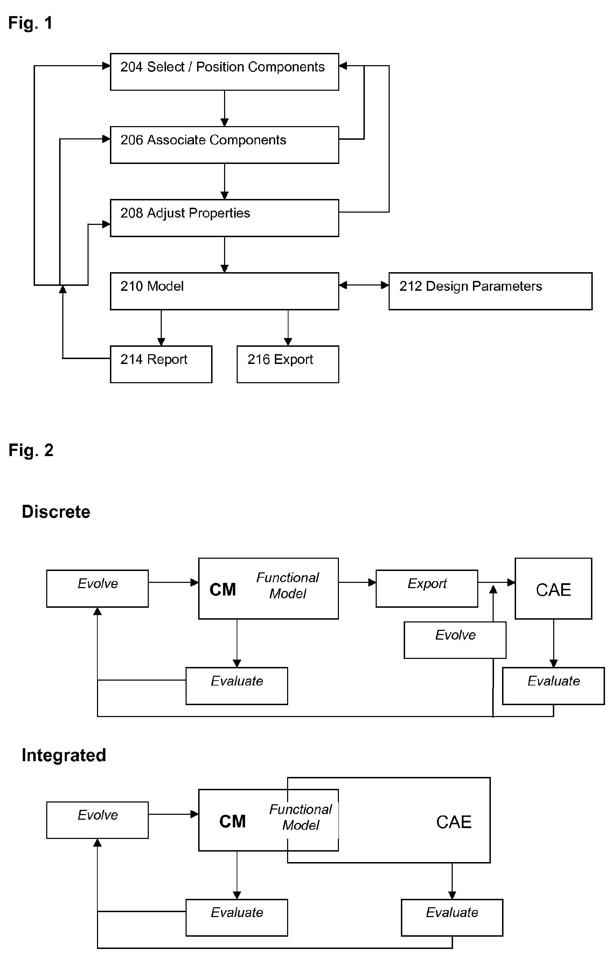

Referring now to Fig. 1, which shows a flow chart of a process for designing a rotating machine, a user, in particular, a designer, is able to create a layout for a design and to refine the model of a design as it evolves. The rotating machine may be simple or complex, including, for example, gear-boxes, drive trains, transmissions, electric motors, generators, pumps, turbines and the like.

In a first stage 204, the designer selects one or more components for the rotating machine. The components can be chosen from a library or list of components including, for example, gears, gear sets, epicyclic gear sets, Ravigneaux planetary gear sets, hypoid gears, spiral bevel gears, skew gears, face gears generators, motors, rotors, stators, clutches, shafts pumps, turbines or bearings and the like. The components can be selected from a list of words corresponding to the component (such as shaft, gear, bearing, clutch, etc), or they may be selected from a list of graphical items representing the components, such as, for example, stick diagrams. Typically, after each item has been selected, the designer can position it within a graphical user interface.

Upon their creation, the components can be given default properties. For example the default properties are set according to their application. If the package is set up to be for multi-megawatt gearboxes (e.g. Wind Turbines or Marine Gearboxes) then the default sizes of the components are different from if the package is intended for use with kilowatt-sized gearboxes (e.g. automotive). In addition, the default setting for the units and the scale on the canvas are modified accordingly.

In step 206, selected components are associated to give the basic framework of the conceptual design. The associations or connections include, for example, meshing of gears, connections of clutches between shafts, connections to housings (ground points), joins between shafts, a power load and the like.

In step 208, the designer can adjust properties of the selected components and of their associations with other components to meet the requirements of the design. Adjustments include, for example, changing the position of the components, sizing of gears, defining gear ratios, adjusting gear face widths, changing the size of clutches, changing shaft diameters, adjusting the positions of bearings and gears and the like. This includes defining one or more power flows through the rotating machine or through specified components of the machine.

This leads in step 210 to a functional model that functions according to the adjusted or original properties of the components and their associations or connections. The functional model produced at step 210 is a functional working model that allows the designer to see how well the conceptual design achieves the basic design targets of ratio, torque/power capacity, size and the like.

The analysis of the functional model and associated product definition provides in step 214 various reports to the designer. These may include, for example, an analysis of power flows through the device or components of the device, an analysis of gear sizing, an analysis of the weight, an analysis of the cost, an analysis of gear capacity, an analysis of the clutch torque capacity, an analysis of bearing load or housing/casing load, an analysis of a suitable dynamic load factor corresponding to a minimum required dynamic capacity of a roller bearing and the like.

Data representing the conceptual model can be exported in step 216 in a format for assessment in one or more other CAD/CAE packages. This can be done at any point in the design process if the designer wishes to a more detailed assessment of system or components of the rotating machine.

The process described above is iterative, and the designer may return to previous stages in the process to modify component properties or the way components are associated or connected according to reports generated in step 214 as shown in Fig. 1. Certain components may be removed and replaced with others in order to achieve a conceptual design which meets the design requirements. In addition, the process may be executed a number of times with an increasingly complex concept. Thus step 204 may be performed to select two shafts and two gears; step 206 may be done to position the gears on the shafts and make them mesh, and step 208 leads to an adjustment of the size of the gears, or their ratio. The whole process may then be repeated for further additional components of the conceptual design. In this manner executing the steps a number of times allows the engineer to investigate designs that have a progressively higher level of performance as judged by the analysis methods used.

The process for modelling a conceptual design is thus easy to use and flexible, and provides the designer with a functioning model of the conceptual design at every stage.

In an optional stage 212, design parameters for the rotating machine can be specified. The design parameters relate, for example, to loadings, power flows, size, packaging, operating temperature, or to other design-specific parameters.

This gives the designer a working concept model of a design that is likely to meet the parameters specified.

The designer interacts with the design process of the invention by interactive display means and a graphical user interface of a computer system.

The interactive display means includes touch screens, interactive white boards and the like connected to a processor. It also includes computer monitor and pointing device combinations, including a mouse, a graphics pad, and the like. The processor can be, for example, a processor in a stand-alone computer, a networked computer, a notebook computer, a notepad computer or a smart phone.

Simple and efficient modelling of the transmission system is part of an integrated design process for detailed development of the transmission. When this stick diagram is created, it automatically creates a functional model of the transmission and associated product definition that can be used for further, more detailed CAE analysis of the transmission. Such detailed analysis is needed in the latter parts of the design process, and for such analysis to be carried out, more detail needs to be added. The set up of the software is such that the stick diagram can be used as a basic transmission functional model to which further technical details can be added later in the design process, for the purposes of more detailed analysis.

For example, the function of the shafts may start off simply as a definer of the axis of rotation for a gear, for a kinematic analysis of torques and speeds; then the shaft sections are defined and the shaft's mechanical properties are calculable by representing the shaft sections as 1 D Finite Elements such as, for example, Timonshenko beams, for use in a torsional static or dynamic calculation; then bearings that support the shaft by simple supports or linear stiffness supports are defined and the shaft/bearing system is calculable in a linear static and/or dynamic analysis; then the bearings are converted to more detailed definitions which permit the non-linear calculation of radial, tilt and axial stiffness due to Hertzian contact as part of the overall shaft/bearing system; then the simple mathematical formulation of the shaft section as a 1 D Finite Element such as a Timoshenko beam can be replaced by a 3D stiffness matrix from a 3D Finite Element model definition, for example.

Similarly for gears, the simplest representation of a gear is in terms of the ratio, centre distance and face width only and simple analysis methods of torque capacity for the given centre distance or pinion diameter, ratio and face width are possible; next, tooth numbers can be added to the gear definition and the calculation of tooth passing frequency can provide insight into the noise characteristic of the machine; next, details such as the module, pressure angle, helix angle, addendum modification coefficients, addendum, dedendum, root fillet radius, material specification, surface roughness etc. can be added and the stress, durability and efficiency of the gear can be calculated according to standards such as ISO 6336; next, details such as lead crowning, tip and root relief, lead slope etc. can be added and a loaded tooth contact analysis calculation can provide the stress, durability, transmission error and efficiency of the gear under the loaded and misaligned condition; and finally, the model of the gear can be replaced by a model based on finite element analysis, either simple or a complex 3D mesh, and the stress, strain, deflection, loading at each point of the tooth can be calculated at each part of the mesh cycle.

For the gearbox housing/casing, the initial definition has the housing as a rigid element that supports the bearings with no deflection; next, the housing can be represented by a reduced stiffness matrix whereby the outer ring of the bearing is assumed to move with all 6 degrees-of-freedom as a single point according to the stiffness of the housing, which is represented by a [6n x 6n] stiffness matrix, where n is the number of bearings in the system; next, the support of each bearing is modelled in greater detail so that the contact between the bearing outer ring and the housing can be analysed and the ovalisation of the bearing inner and outer rings under load can be calculated.

The initial stick diagram does not need to have bearings defined, since the calculations of speeds and torques within the system can assume simply that all shafts are supported and able to rotate about their own axis. The next step of refinement is to define the location of the bearings and create supports for the shafts at this position. In keeping with the idea of making the initial model as simple as is necessary to make the design decision, these supports are either simple supports (infinite radial stiffness, zero tilt and axial stiffness) or are allocated a default, finite stiffness. Either way, this allows an initial calculation of the static loading of the shaft/bearing/gear system to be calculated.

From this initial calculation, guidance can be given for the size of the bearings required, and also the forces that are transferred to the housing (casing) can be calculated and reported for the benefit of the housing designer.

Also, from this initial calculation of the bearing loads and the number of cycles, it is possible calculate the required dynamic capacity of the bearing if such a simple support were to be replaced by a rolling element bearing, and this can be provided as valuable information to the designer who can base the bearing selection on this information.

The process of defining the simple support, calculating the bearing loads and selecting the appropriate roller bearing can be modified by defining the simple support in terms of a radial and axial support, axial support only, uni-directional axial support, tilt support and tapered roller support (uni-directional and bi-directional) and the corresponding bearing load capacity calculation can be made valid for different bearing types, such as tapered roller bearing, thrust needle roller bearings, thrust ball bearings, cylindrical roller bearings (with or without ribs), angular contact bearings and double row versions of all such bearings.

In Fig. 1, data representing the conceptual model is shown as being exported in step 216 in a format for assessment in one or more other CAD/CAE packages. It is to be understood that the data may also be analysed by one or more other CAD/CAE packages which are integrated with the Concept Modeller ("CM"). Thus in the upper panel of Fig. 2, the user interacts with CM to create a layout, as described above, which in turn leads to the formation of a functional model. This functional model can be used as a basis for calculations to evaluate the layout against performance criteria. Depending on the evaluation, the user may want to modify or evolve the layout in order to try and meet the performance criteria, as described above in relation to Fig. 1, for example. However, there comes a point when the analysis required is more complex than the approaches provided by CM. In this case, the functional model is exported in a format for inputting into one or more other CAD/CAE packages able to handle more detailed model definitions and complex analyses. Again, the user can evaluate the model exported to one or more other CAD/CAE packages for its performance, and depending on those results, further evolve the layout.

The lower panel shows a similar approach in which the capability to perform more complex calculations and analysis is integrated into the Concept Modeller, making transition from one to the other more straightforward and "invisible" to the user.

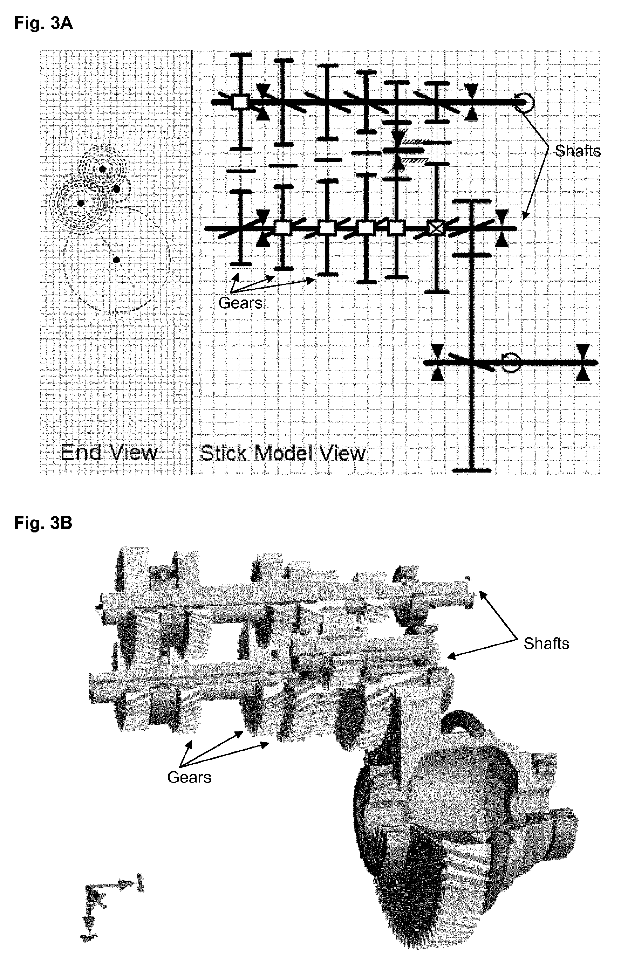

The user may also interact with the model to modify it so as to provide increased model complexity and its performance is assessed using analysis methods that are increasingly complex. Figs. 3A-D show this evolution.

In Fig. 3A, the user has created a stick diagram of a gear box having a number of gears mounted on parallel shafts. The bearings are defined as simple supports and the gears by ratios alone. The housing is not defined and is assumed to be rigid. The shaft sections have not been defined and so the shaft stiffness is assumed. The powerflow analysis can be performed and the torque capacity and recommended centre distance for the gears, plus the bearing and housing loads can be calculated.

In Fig. 3B, the shafts sections are now defined and so the stiffness can be calculated by represented the sections as Timoshenko beams. The gears have been further defined so that the gears can be rated to ISO 6336 and the tooth numbers allow the tooth passing frequencies to be calculated. The bearings are now defined in terms of their roller bearing type so that the dynamic capacity can be linked to the bearing loads and the bearing durability calculated. The bearing non-linear stiffness can be calculated.

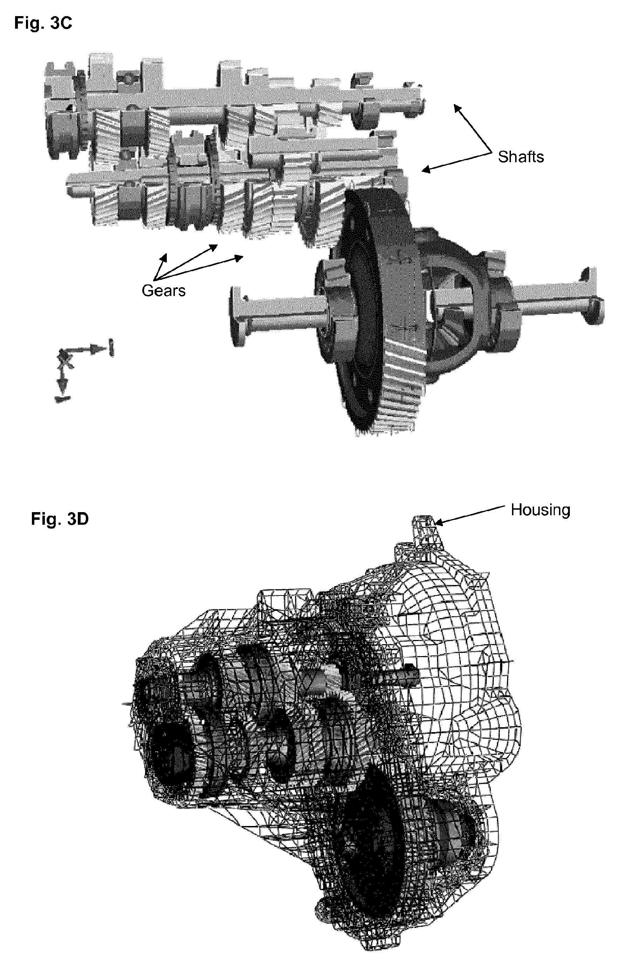

In Fig. 3C the mode has been refined further. One of the shafts, the differential cage, is non-axisymmetric and the 1 D Timonshenko beam representation has been replaced by a 3D Finite Element mesh, giving a more accurate analysis of the bearing loads, gear misalignment and shaft deflection in this area.

In Figs 3A-3C the housing is not defined and thus it is assumed that the bearings are supported by a rigid structure. in Figure 3D the housing is represented by a 3D Finite Element mesh, or a reduced mass and stiffness matrix to represent its mechanical properties, and this is used to support the bearings. Now, the deflection of the housing is accounted for in the full static analysis of the whole gearbox, and the mass and stiffness of the housing affect the dynamic behaviour of the gearbox. The shaft deflection, bearing deflection, misalignment, load and life, and gear load, misalignment, durability, torque capacity, transmission error, efficiency are all affected by the housing stiffness. The level of complexity of analysis and insight available is far greater than in Fig 3A, but the modelling time is also much greater and the scope for making changes is much less. Yet, at the same time, the transition from Fig 3A to 3D is smooth, within integrated or discrete software packages, and allows iterative design improvements to be made. This is the key essence of the invention.

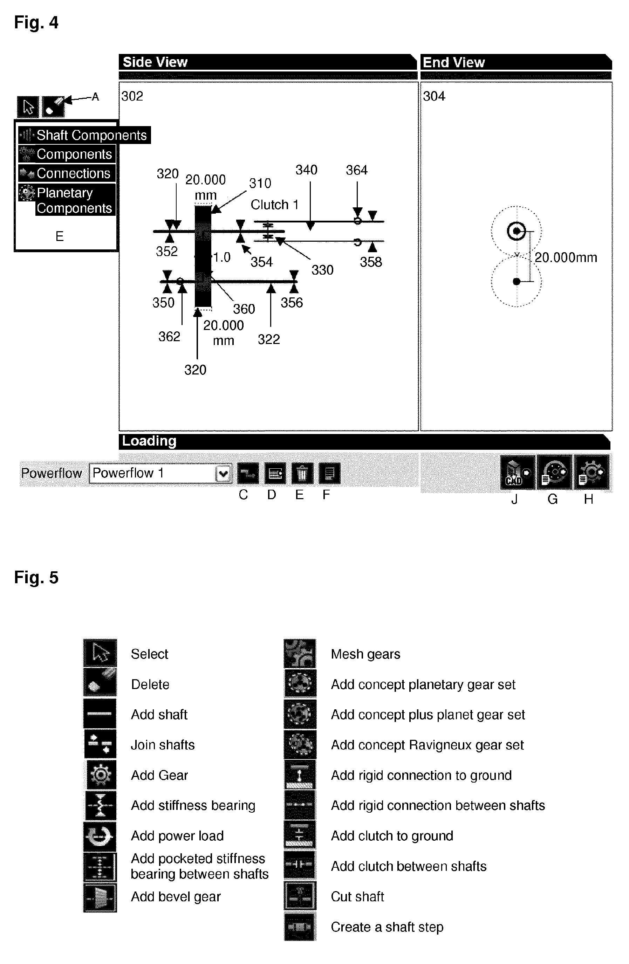

Fig. 4 shows an example of a graphical user interface displayed to the user and which allows the user to interact with the process of the invention to create a schematic of the kind shown in Fig. 3A. In Fig. 4 the schematic of the rotating machine is a functioning model of the rotating machine itself.

The work area comprises one or more views 302,304. Two such views are shown in Fig. 3 corresponding to a side view 302 and an end view 304 of the rotating machine being designed. The side view may be either a true representation of the view of the rotating machine as viewed along a given axis, or it may be a folded out representation of the rotating machine through one or more cut planes. The rotating machine in Fig.4 is shown using a "stick diagram" form as is commonly used, in which the gears are represented by rectangular elements. However other diagrammatic representations of the rotating machine components can be used, including "stick diagrams" in which the gears are represented by a generally "I"-shaped element.

In the example shown in Fig. 4, two gears 310, 312 are respectively mounted on two shafts 320,322. Shaft 320 is connected via clutch 330 to concentric shaft 340. In this example, shafts are shown as being arranged in a general horizontal direction, but it is to be understood that shafts may be aligned in any direction, such as vertical, diagonal and the like, and that machines with perpendicular shafts can be defined and analysed. Shafts 320,322,340 are supported on bearings 350,352,354,356,358. Initially, the bearings are very simple shaft supports, with no user-defined information on the radial, axial or tilt stiffness. As the model matures, additional stiffness data can either be defined by the user or calculated.

An example of a power flow 360 between an input 362 and an output 364 is shown.

Selecting, positioning and connecting components on the display to create the rotating machine assembly using the process of the invention will now be described in greater detail. The graphical user interface presented to the user provides a number of icons for issuing commands, and examples of these are shown in Fig. 5.

In a first step, components shown in List B, which includes sets of shaft components, other components, and planetary components, may be selected and positioned on the display. Typically components are selected by displaying within the graphical user interface a list of the components and receiving a user selection from the list. The graphical user interface allows the designer to change the position of a component by selecting the component (e.g. by clicking or tapping) and then moving it to a new position (e.g. by dragging it or nudging it). Typically components are moved by receiving a user selection of a component for positioning and modifying the position according to the user request. These steps can be repeated until all selected components have been positioned. This exemplifies step 204 of Fig. 1.

It also allows the designer to delete a component by engaging button A (e.g. by clicking or tapping) and selecting a component on the canvas (e.g. by clicking or tapping). Typically one or more of said components are deleted by displaying within a graphical user interface of a computer system the components, receiving a user selection of one or more of the components for deleting; and deleting the one or more of he components according to the user request.

In a second step, which exemplifies step 206 of Fig. 1, the interface allows the designer to associate or connect components selected in the first step. Typically associations between components are created by displaying within a graphical user interface of a computer system the components, receiving a user selection of at least two of the components for associating, and associating the components according to the user request.

For example, parallel shafts 320 and 340 may be connected concentrically as shown by selecting "Connections" from List B, and choosing "Join Shafts" from a submenu list (not shown). The designer then selects two shafts (320,340) to be connected concentrically on the canvas, and the software repositions 340 so that the centre line of 320 and 340 coincide, and connects the end of 320 and the forefront of 340 so that the length of the joined shaft becomes the sum of the length of 320 and 340.

To assist the designer in the iterative design process, a shaft may be separated into two separate shafts by means of a shaft cutting tool. This has its own icon and the location of the cut is defined by a mouse or other pointing device.

Two concentric shafts 320,340 can be connected with a clutch 330 as shown. The designer chooses "Connections" from List B, and then "Add Clutch between Shafts" from a submenu list (not shown). Two shafts 320,340 aligned concentrically on the canvas are selected by the designer, and the software creates a link between the two shafts. This link has the property that it can either be defined as transmitting power or not transmitting power, depending on the powerflow condition. It can either be torsionally and radially rigid or have default values of radial and torsional stiffnesses. It will have default clutch dimensions.

Other connections are possible.

For example, two concentric shafts can be connected "rigidly". The term "rigid" represents the functionality of a spline, a weld, a shrink fit or another such connection. This can be thought of as a rigid connection, but in the model this is a conceptual entity used to define the fact that these shafts are connected by some physical entity such as a weld or a spline where it is intended that the connection can transmit power at all times. In the analytical model its radial, torsional and axial stiffness will have default values which may be high or may be infinite. After choosing "Connections" from List B, and selecting "Add Rigid Connection between Shafts" from a submenu list (not shown), the designer can then select two shafts (320,340) to be connected concentrically on the canvas. The software creates a "rigid" element between shafts 320,340 and connects shaft 320 and shaft 340 using the rigid connection. In the case of a welded join, it is to be noted that a weld is rigid in all 6 degrees of freedom, not just radial.

For example, a shaft can be connected to ground rigidly, to represent the fact that, for example, it may be mounted into a housing. By selecting "Connections" from List B, and choosing "Add Rigid Connection to Ground" from a submenu list (not shown), the designer can then select a shaft to be grounded on the canvas. The software creates a "rigid" element (as defined previously) between the selected shaft and ground, and connects the shaft and ground with the "rigid" connection.

For example, a shaft can be connected to ground with a clutch, to represent the fact that the shaft is connected to a housing via a clutch. After choosing "Connections" from List B, and selecting "Add Rigid Clutch to Ground" from a submenu list (not shown), the designer can then select a shaft to be connected to ground using a clutch. The software creates a link between the two shafts. This link has the property that it can either be defined as transmitting power or not transmitting power, depending on the powerflow condition. It can either be torsionally and radially rigid or have default values of radial and torsional stiffnesses. It will have default clutch dimensions.

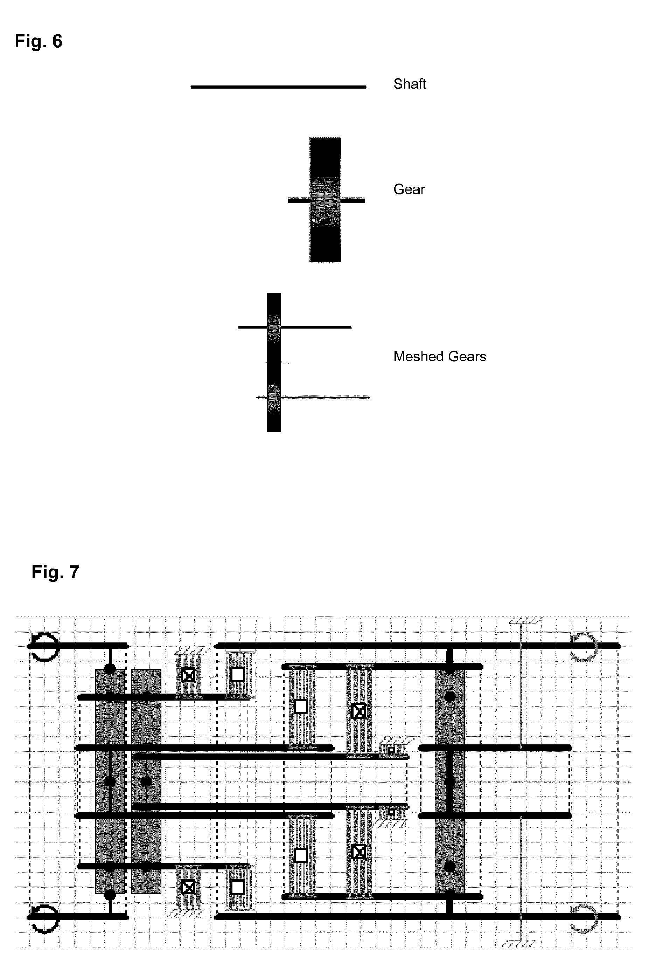

For example, gears 310,320 can be meshed as shown. The designer chooses "Connections" from List B, and then "Mesh Gears" from a submenu list (not shown). Gears 310, 320 are then selected, and the software repositions one of the selected gears axially so that two gears are aligned in the axial direction and either sets the axial distance between shafts 320,322 to accommodate the gears, or adjusts the size of the gears, as shown in the example shown in Fig. 6 where the diameter of both gears is equal and the gear ratio is 1.0.

In a third step, which exemplifies step 208 of Fig. 1, the interface allows the designer to adjust the properties of components in the conceptual design.

For example, a power load may be created by adding power loads to shafts. The designer chooses "Connections" from List B, and then "Add Power Load" from a submenu list (not shown). The designer then selects a shaft on the canvas to add the power load and the software adds the power load to the shaft, either without any values for speed, torque and power or using default values.

For example, power flows can be added to power loads defined on the canvas. After choosing "New Powerflow" from Button C, the software creates a new powerflow with name, duration and default temperature. The designer then indicates (e.g. by clicking or tapping) which power load is an input power load 362 and which power load is an output power load 364. The software sets the power load clicked first as the input power load and the power load clicked second as the output power load. A search for a powerflow path starting at the input power load and ending at the output power load, using, for example, graph theory is executed. If an appropriate path is found, a new powerflow is created (if a path is not found, a powerflow is not created), and power loads are added to the power flow definition by becoming the points at which power enters and exits the transmission. A powerflow 360 is displayed on the workspace.

For example, powerflows can also be defined by clicking on the input power load (the point at which the power enters the driveline system), then clicking on successive shafts and gears that are loaded and clutches that are engaged. The powerflow definition is completed by clicking on the output power load (the point at which the power exits the driveline system). The software gives power loads, torques, speeds, durations and temperatures typed in a properties table to the defined powerflows.

For example, powerflows can be defined. The designer chooses (e.g. by clicking or tapping) on button (D) and editing power, torque, speed, duration, engaged clutches and temperature in the properties table. The software gives power loads, torques, speeds, durations, engaged clutches and temperatures typed in the table to the defined powerflows.

For example, defined powerflows can be deleted. The designer chooses a powerflow (e.g. by clicking or tapping) on button (E), and the software removes the powerflow.

For example, the size of any component or its properties can be changed by selecting it and dragging it.

For example, a gear ratio of a gear pair or gear set can be changed by dragging the mesh created between the gear pair. The software changes the diameters of the gears as the gear ratio is changed. The packaging space occupied by the gear pair and the torque capacity, weight and cost of the gear set are automatically updated when this is done.

For example, the face width of a gear can be changed by dragging the edge of the gear and moving the mouse along the shaft axis. The packaging space occupied by the gear pair and the torque capacity, weight and cost of the gear set are automatically updated when this is done.

For example, the centre distance of a gear pair can be changed by dragging the axis of the shaft or assembly on concentric shafts on which one of the gears is mounted. Both The packaging space occupied by the gear pair and the torque capacity, weight and cost of the gear set are automatically updated when this is done

For example, the axial position of a gear can be changed by dragging centre of the gear and moving the mouse along the shaft axis.

For example, the size of a clutch can be altered in the radial direction by a click-and-drag action. Both the packaging space occupied by the clutch and the torque capacity of the clutch are automatically updated when this is done.

For example, the size of the clutch can be altered in the axial direction by a click-and-drag action. In doing so, additional clutch plates are added, so both the packaging space occupied by the clutch and the torque capacity of the clutch are automatically updated when this is done.

In this way, a rotating machine assembly can be easily designed and displayed in a stick diagram or profile diagram format. Examples of some stick diagram schematics are shown in Fig. 6, and a profile diagram in Fig. 7.

This is not only a graphical representation of a transmission, but also a working model of the function of the rotating machine assembly, on which calculations can be carried out to predict the function and performance of a rotating machine assembly.

The "stick diagram" is a very efficient and logical way of representing a transmission that consists of external gear sets. The shaft is drawn along its centre line. However, where planetary gear sets are involved, or systems with many concentric shafts are involved, it is necessary to represent the shafts in terms of the outer diameter of the shaft rather than the centre line, or in terms of outer diameter and inner diameter. A further refinement is that the user can automatically switch between views.

A shaft is created as a single section. The user can define "steps" in this shaft to create two or more sections. Outer diameters of these sections can be specified, which means different sections have different outer diameters. The outer diameters are changed in a click-and-drag action. The shaft is created with a default inner diameter, which is given a proportion of the outer diameter. As the outer diameter is changed, the inner diameter is automatically changed so as to maintain the relationship between the inner and outer diameters without any need for further user interaction.

In changing the shaft diameters, it is possible for the change in diameter between two sections to be substantial, so that the inner diameter of one section is greater than the outer diameter of the adjacent section. If a simple step between the two adjacent sections were created, a discontinuity would have been created, akin to a break in the shaft, which would mean that the shaft would not be able to transmit torque, either analytically or in physical reality. To solve this problem, when a single shaft step is introduced in this package by the user, the analytical model defines two steps separated axially by the default thickness between the inner and outer diameters of the shaft. This "connecting" shaft section has the same engineering properties (length, outer diameter, inner diameter, material properties) as the other shaft sections, so there is no special "component" or "object" created to represent it. This shaft section in between these two steps acts as a transition between the two shaft sections, whose diameters are being altered by the user. The creation and manipulation of this transitional step is automatically carried out by the package, without the need for direct user interaction.

The user can change the axial location of the shaft steps by a click-and-drag action. When this is done, both the shaft steps that define the transitional shaft section are moved at the same time, thus maintaining the length of the transitional shaft section and its function within the model. All this is done automatically and without the need for direct user interaction.

"SIDE VIEW" and "END VIEW". The software simultaneously shows the side view and the end view of the transmission. The end view allows the user to define planes that cut through the centres of the various transmission shafts so as to define an expanded view of the transmission in the side view.

The stick diagram can yield a 3D model of a transmission that can be exported to CAD for a check of the packaging of the transmission within its environment. Although the interface is in 2D, orthogonal views allow the 3D representation of the transmission to be defined. This is exported as solid geometry to a CAD package so that the size and shape of the transmission can be checked relative to the space into which it will eventually have to be assembled. All of this can be achieved with a bare minimum of details of the design having been completed.

In a fourth step, powerflow analysis, static analysis, cost, weight, gear sizing, gear torque capacity, bearing loads, housing loads and clutch torque capacity can be determined and reported. This exemplifies step 214 of Fig. 1.

For example, for powerflow analysis, the designer selects button (F) and runs a powerflow analysis using power loads defined above. This analysis calculates the speed, torques and powers at all points in the rotating machine for each powerflow. It can be achieved either by a kinematic calculation, with all the components treated as rigid elements, or with the components having a finite stiffness and with the system solved by creating a matrix, M. The overall gear ratio for the output/input is calculated based on the calculated angular velocities. Output torque is calculated using input torque and the gear ratio.

For example, for a clutch capacity report, the designer selects button (G) to create a clutch torque capacity report based on clutches defined in above. The software calculates clutch sliding speed, considering the speed difference between contacting clutch plates. Using a net clamping force, coefficient of friction, number of friction surfaces and mean radius of the clutch, a torque capacity and safety margin for the clutch is calculated. The report typically includes transmitted torque, sliding speed, torque capacity and safety margin (static torque safety factor).

For example, for a gear sizing report, the designer selects button (H) to create a gear sizing report for gear pairs defined above.

Four assessment methods are available:
Method 1 where the torque capacity is dependent on Centre distance of a gear pair or gear train only.
Method 2 where the torque capacity is dependent on Centre distance and Face width of a gear pair or gear train only.
Method 3 where the torque capacity is dependent on Centre distance, Face width and Gear ratio of a gear pair or gear train only.
Method 4 where the torque capacity is dependent on Ring gear (or sun gear) diameter and ratio only for a planetary gear set.

The software uses various constants kn (n = 1 to 4) for the method selected by the designer. Using methods 1 to 3, torque capacity is calculated using kn, centre distance, face width and gear ratio (parameters used depend on the method selected). For method 4, k4, ring/sun ratio, ring gear diameter and face width are used for calculating the torque capacity. Since the powerflow analysis has been carried out the torque applied at each gear pair, gear train or planetary set is known. A recommended centre distance is calculated using methods 1 to 3 using kn, torque, face width and gear ratio. For method 4, k4, torque, number of planets, ring/sun ratio and face width are used for calculating the recommended ring gear diameter. A safety factor is calculated by dividing actual centre distance shown on the canvas by the recommended centre distance. For planetary gears, a safety factor is calculated by dividing actual ring gear diameter shown on the canvas by the recommended ring gear diameter. The calculated safety factor is displayed next to the targeted gear pair on the canvas. A report including gear sizing calculations for method 1 - 3, and 4 (if any planetary gears are included in the gearbox) is created. The pinion diameter is directly calculable from the centre distance and the ratio; hence the same methods are available in the form where pinion diameter replaces centre distance. This means that each of the methods involving kn (1 to 4) can be modified to be carried out using the diameter of the pinion gear instead of the centre distance as the key parameter, with corresponding values of kn (1 to 4) calculated.

Assessment of the size of the gears is carried out by simple methods that require no knowledge of gearing. Normally, the assessment of the suitable durability of the gear is made using "rating" methods such as ISO 6336 or AGMA 2001, which require input data such as number of teeth, pressure angle, module etc. Therefore they require the engineer to have defined the gears in sufficient detail and also to have knowledge of the appropriate values. In this software implementation, three simpler methods are used for external gear pairs and gear sets, which require (i) centre distance only (ii) centre distance and face width (iii) centre distance, face width and ratio. Whilst these methods are not as accurate or sophisticated as others, they are usable by engineers who are not familiar with the details of gear design and so can be used for the initial stages of gear design. Similarly, one simple method is used for planetary gear sets, which requires ring gear (or sun gear) diameter and ratio only.

Such sizing methods require "constants", related to the application and material used, which can be obtained by analysing existing transmissions using the same simple analysis methods. In this software implementation, the same tool can be used to analyse an existing transmission. This data is saved to a database and can be re-used in the creation of new transmissions.

As stated previously, each of the methods involving the constants can be modified to be carried out using the diameter of the pinion gear instead of the centre distance as the key parameter, with corresponding values of the constants calculated.

Various gears and gear assemblies can be used.

For example, Ravigneaux planetary gear sets can be defined as an assembly of objects in a single user action. Ravigneaux gear sets are complex arrangements of gears but are commonly used for automatic transmissions in the automotive industry. In this software package they are reduced to their most abstract level so that an initial basic model is created by defining the two basic ratios of the Ravigneaux set and the basic structure (two suns and one ring gear or two rings gears and one sun). Even with this simple definition, the Ravigneaux can be connected to other planetary sets and clutches to achieve several ratios for the overall transmission, thus initiating the transmission design process with minimum effort for the engineer.

Different Ravigneaux configurations are achieved simply by specifying the sign of the ratio. The different possible structures, whereby each planet set of the Ravigneaux set is either a plus-planet or minus-planet, is selected with a minimum of user input and effort simply by the ratio sign of the relevant gear set. The design and modelling process is thus as smooth and as intuitive as possible.

For example, full assemblies of planetary gear sets, already mounted on shafts, can be defined as an assembly of objects in a single user action. When all planetary sets are created, they come as complete assemblies, not just in terms of the gears that mesh, but also the mounting onto shafts and the creation of suitable planet carriers. This allows a quick start to the transmission design and modelling process, so that its inclusion into a complete transmission can be carried out as quickly as possible.

For example, the previous process can permit roller bearings under the planet gears to be included in the assembly of objects defined in a single user action.

For example, this overall design process also includes hypoid, spiral bevel, skew and face gears.

When the planetary gear set is created, and the shafts, onto which the gears are mounted, are automatically defined, the shaft diameters are defined so as to be appropriate for the gear diameters. In the very early stages of the product definition, the engineer will wish to redefine the gear diameters to a size appropriate for the application. When this is done, the shaft diameters are automatically updated, without the need for direct user intervention.

The size of all clutch packs and all gear sets in a transmission are assessed within a single user window. Within the transmission design process, the principal components affecting the overall size of the transmission are gears and clutches. Both have to be sufficiently big to transmit the torque, but there is a penalty to excessive size in that the transmission may not fit within the eventual application and/or it will be too heavy. In this package, the size (hence packaging) of all gear sets and all clutches can be modified in a single GUI window, with key results on their performance (torque capacity, cost and weight) being reported simultaneously for all the key components.

Data relating to the arrangement created in Stages 1 and 2 can be export to a CAD format for further assessment. The designer selects button (J) to export CAD data of the concept gearbox design shown on the canvas. Various CAD formats can be selected, for example, STEP CAD Format (stp) and IGS CAD Format (igs). The software obtains a list of all components included in the gearbox shown on the canvas. Geometry of each component in the list of components is extracted and passed to third party software. This generates basic shapes, relating to the geometry. This process is repeated for each component in the list.

Simple and efficient modelling of the transmission system is part of an integrated design process for detailed development of the transmission. When this stick diagram is created, it automatically creates an analytical model of the transmission that can be used for further, more detailed CAE analysis of the transmission. Such detailed analysis is needed in the latter parts of the design process, and for such analysis to be carried out, more detail needs to be added. The set up of the software is such that the stick diagram can be used as a basic transmission analytical model on to which further technical details can be added later in the design process, for the purposes of more detailed analysis.

1 D torsional models for dynamic analysis are created. From a simple, stick-diagram representation of the transmission, a 1 D torsional dynamic analysis model is automatically created. This can be exported to another CAE package for the creation of a gear shift model or shift strategy etc.

The present invention also includes a computer readable product for computer-aided engineering design of a rotating machine assembly, the product comprising code means designed for implementing the steps of the method disclosed above.

The present invention also includes a computer system for computer-aided engineering design of a rotating machine assembly, the system comprising means designed for implementing the steps of the method disclosed above.

In a further embodiment, the present invention includes a computer-implemented method, comprising: within a graphical user interface of a computer system for computer-aided engineering for designing a rotating machine assembly, displaying surrogates corresponding to components for the assembly and receiving a user selection of a surrogate. A schematic representation of the component corresponding to the surrogate is then displayed. a user instruction for positioning the schematic representation in the interface is received and the position of the schematic representation is modified according to the user. Optionally, these steps can be repeated on receiving a user instruction for repeating the steps.

The surrogate can be a descriptive word corresponding to the component, or it can be an icon representing the component. The step of displaying the surrogates can comprise displaying a list of surrogates in a menu.

The schematic representation can comprise a stick diagram or a profile diagram.

The method further includes the steps of receiving a user selection of at least two schematic representations for associating and creating associations between them. Optionally, these steps can be repeated on receiving a user instruction for repeating the steps.

The method further includes the steps of receiving a user selection of one or more of said schematic representations for deleting and deleting said one or more of said selected schematic representations according to the user request.

The method further includes the steps of receiving a user selection of a schematic representation and modifying a property of a component corresponding to the selected schematic representation according to the user request. Optionally, these steps can be repeated on receiving a user instruction for repeating the steps.

## Claims

1. A method for designing a gearbox, comprising the step of:
(a) a user creating within a graphical user interface of a computer system a layout of said gearbox according to the steps of:
receiving a user selection of components for said gearbox;
a user positioning said selected components;
a user creating associations between said selected components; and
a user adjusting properties of said components and said associations;
(b) forming a functional model of said gearbox from said layout, said product definition consisting of:
said associations;
relative positions of said selected components; and
properties of said selected components and said associations;
(c) performing calculations of gear durability based on the following elements from said functional model:
centre distance only;
centre distance and face width; or
centre distance, face width and ratio;
(d) evaluating the layout against performance criteria for gear durability;
(e) modifying a gear property, according to the steps of:
receiving a user selection of a gear;
setting or modifying a property of said selected component or of said selected association according to a user request, said step of modifying said gear property automatically modifying diameters of the corresponding gears without any need for further user interaction; and
updating said functional model;
(f) and executing a number of times said steps (d) and (e) to produce a gearbox design with the required gear durability without requiring information on number of teeth, pressure angle, module, addendum, or dedendum.

2. A method according to claim 1, wherein said step of modifying a property comprises a click-and-drag action.

3. A method according to claim 1 or claim 2, wherein a gear torque capacity of said gearbox design produced in step (f) is calculated based on the following elements from said functional model:
centre distance or pinion diameter;
centre distance or pinion diameter and face width;
centre distance or pinion diameter, face width and gear ratio; or
ring gear (or sun gear) diameter, face width and ratio;
and a respective constant kn, where n=1 to 4;
and the recommended centre distance or ring gear diameter is calculated using the properties:
torque and ratio;
torque, face width and gear ratio; or
torque, face width and ratio;
and a respective constant kn, where n=1 to 4.

4. A method according to claim 3, additionally including the steps of:
(a) evaluating the layout against performance criteria for torque capacity;
(b) modifying a gear property, according to the steps of:
receiving a user selection of a gear;
setting or modifying a property of said selected component or of said selected association according to a user request, said step of modifying said gear property automatically modifying diameters of the corresponding gears without any need for further user interaction; and
updating said functional model;
(c) and executing a number of times said steps (a) and (b) to produce a gearbox design with the required torque capacity.

5. A method according to any preceding claim, including the step of: setting a first limit value for a property;
setting a second limit value for a property;
setting a step function;
varying a value of a property between said first limit value and said second limit value according to the step function;
predicting a function and/or a performance of said rotating machine assembly at each value; and
reporting said function and/or said performance of said rotating machine assembly at each value.

6. A method according to any preceding claim, wherein said components include gears, gear sets, epicyclic gear sets, Ravigneaux planetary gear sets, hypoid gears, spiral bevel gears, skew gears, face gears generators, motors, rotors, stators, clutches, shafts pumps, turbines or bearings.

7. A computer readable product for computer-aided engineering design of a rotating machine assembly, the product comprising code means designed for implementing the steps of the method according to any of claims 1 to 6.

8. A computer system for computer-aided engineering design of a rotating machine assembly, the system comprising means designed for implementing the steps of the method according to any of claims 1 to 6.
